Europäisches Patentamt

European Patent Office

Office européen des brevets

(19)

(11) Numéro de publication : **0 518 729 B1**

## FASCICULE DE BREVET EUROPEEN

(12)

(45) Date de publication du fascicule du brevet :
27.07.94 Bulletin 94/30

(51) Int. Cl.⁵ : **H03L 7/16, H03L 7/10**

(21) Numéro de dépôt : **92401506.8**

(22) Date de dépôt : **03.06.92**

(54) **Dispositif de contrôle d'une boucle de phase à changement de fréquence.**

(30) Priorité : **14.06.91 FR 9107318**

(43) Date de publication de la demande :
**16.12.92 Bulletin 92/51**

(45) Mention de la délivrance du brevet :
**27.07.94 Bulletin 94/30**

(84) Etats contractants désignés :
**DE FR GB IT NL SE**

(56) Documents cités :
**EP-A- 0 369 660**
**FR-A- 1 335 450**
**US-A- 4 318 055**
**US-A- 4 523 157**

(73) Titulaire : **THOMSON-CSF**
**173, Boulevard Haussmann**
**F-75008 Paris (FR)**

(72) Inventeur : **Lazarus, Michel**
**THOMSON-CSF,**
**SCPI,**
**Cédex 67**
**F-92045 Paris la Défense (FR)**

(74) Mandataire : **Benoit, Monique et al**
**THOMSON-CSF**
**SCPI**
**B.P. 329**
**50, rue Jean-Pierre Timbaud**
**F-92402 Courbevoie Cédex (FR)**

EP 0 518 729 B1

## Description

L'invention concerne un dispositif de contrôle d'une boucle de phase à changement de fréquence utilisée dans les synthétiseurs de fréquence en général et plus particulièrement dans les circuits de génération de fréquence des Radars Doppler.

Les boucles de phase à changement de fréquence sont utilisées couramment dans les synthétiseurs de fréquence pour générer à partir d'une horloge de référence un signal variable ayant une fréquence prédéterminée stable.

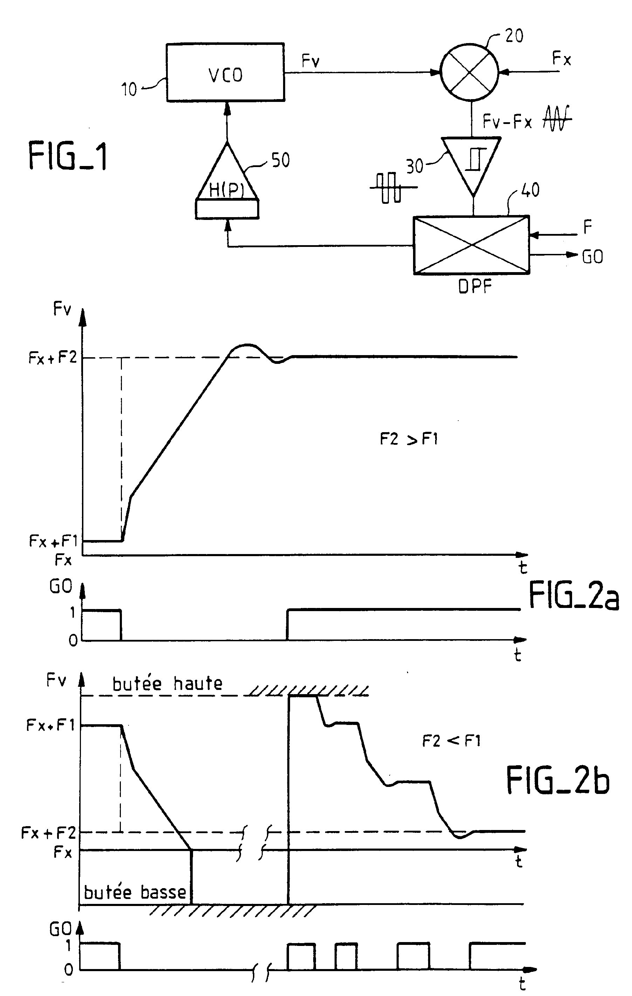

Sur la figure 1, on a représenté un exemple de réalisation d'une boucle de phase à changement de fréquence utilisable dans un synthétiseur de fréquence. La boucle de phase comprend typiquement un oscillateur (10), un mélangeur (20), un amplificateur limiteur (30), un détecteur phase/fréquence (40) et un amplificateur pseudo-intégrateur (50). L'oscillateur 10, tel qu'un oscillateur commandé en tension (VCO), fournit un signal de synthèse ayant une fréquence prédéterminée Fv en réponse à un signal d'asservissement. Le mélangeur 20 relié à l'oscillateur reçoit le signal de synthèse et un premier signal de référence (horloge de référence) ayant une fréquence Fx (fréquence de transposition) pour fournir un troisième signal représentatif d'une fréquence de battement (Fv-Fx). Le premier signal de référence est typiquement engendré par un oscillateur à quartz non représenté sur la figure. Le troisième signal est mis en forme logique par l'amplificateur limiteur 30 pour attaquer le détecteur phase fréquence (DPF) 40. Le détecteur phase/fréquence reçoit par ailleurs un second signal de référence ayant une fréquence F qui peut varier dans une grande plage entre des valeurs Fmin et Fmax avec Fmax/Fmin supérieur à 30. Généralement, le second signal de référence est dérivé du premier signal de référence (division de l'horloge de référence par un entier n). Le détecteur phase/fréquence, connu en soi, détecte ou non une identité de phase (et par suite de fréquence) entre le troisième signal et le second signal de référence pour fournir d'une part un signal de contrôle logique GO et d'autre part le signal d'asservissement (une tension continue) dont le niveau est fonction de l'écart de phase entre le troisième signal et le second signal de référence. Le signal d'asservissement est amplifié par l'amplificateur 50 pour s'adapter à la dynamique de commande de l'oscillateur 10. Dans le cas ou la boucle de phase est verrouillée, la fréquence Fv de l'oscillateur 10 est égale à Fx + F et le niveau logique du signal de contrôle GO est à 1. Dans le cas contraire, le niveau logique du signal de contrôle GO est à 0.

Naturellement le schéma général décrit ci-dessus comporte des variantes. L'une de ces variantes est décrite dans le brevet US-A-4.523.157. Ce brevet décrit dans sa figure 2 relative à l'art antérieur un synthétiseur analogique dans lequel l'amplificateur pseudo-intégrateur 50 de la figure 1 de la présente demande a été remplacé par un filtre passe-bas 6, tandis que l'amplificateur limiteur 30 a été supprimé.

Dans ce type de synthétiseurs, lorsque la fréquence F est dérivée de la fréquence de transposition Fx, par changement de la valeur de l'entier diviseur de fréquence n, la fréquence F passe d'une valeur F1 à une valeur F2 instantanément. Lorsque le rapport F1/F2 est grand, la boucle de phase se déverrouille en phase et le signal de contrôle GO passe au niveau logique 0. Deux cas peuvent se produire:

### CAS 1: F2>F1

Dans ce cas, la boucle reste verrouillée en fréquence et la fréquence Fv de l'oscillateur 10 croît, sous l'action du signal d'asservissement, jusqu'à ce qu'elle soit en phase avec la fréquence Fx + F2. Le signal de contrôle GO reprend alors le niveau logique 1 comme visible sur la figure 2(a).

### CAS 2: F2<F1

on doit alors distinguer deux cas selon la valeur du rapport F1/F2:

- si la valeur du rapport F1/F2 est inférieure à 3 (environ), le comportement de la boucle est similaire à celui du cas précédent, c'est à dire que la fréquence Fv de l'oscillateur décroît jusqu'à ce qu'elle soit en phase avec la fréquence Fx + F2.

- si la valeur du rapport F1/F2 est très supérieure à 3, la fréquence Fv de l'oscillateur décroît brusquement et comme la boucle à une fonction de transfert du second ordre ("overshoot"), la fréquence Fv devient inférieure à la fréquence de transposition Fx ( figure 2(b) ) ce qui provoque une rotation de phase de Pi. La boucle de phase passe alors en réaction, le détecteur phase/fréquence délivrant un signal d'asservissement qui entraîne l'oscillateur vers sa butée basse où il reste bloqué, le signal de contrôle GO ayant alors un niveau logique 0.

Jusqu'à présent, le déblocage de la boucle de phase consistait à prévoir un élément extérieur qui surveille le niveau logique du signal de contrôle GO pour enclencher un processus de déverrouillage lorsque ce signal de contrôle reste au niveau logique 0. Le processus de déverrouillage consiste typiquement à injecter sur l'entrée de commande de l'oscillateur (entrée d'asservissement) une tension plus élevée que celle fournie par l'amplificateur pseudo-intégrateur 50 pour amener l'oscillateur sur sa butée haute. Il faut ensuite appliquer, sur le détecteur phase/fréquence, le second signal de référence à la fréquence F1 puis procéder en plusieurs paliers pour amener la fréquence F du second signal de référence à la fréquence F2 désirée. Un tel processus de déverrouillage ne peut être géré convenablement que par un microprocesseur ce qui est complexe à mettre en oeuvre. Par ailleurs le processus de déverrouillage neutralise plusieurs temps de cycle ce qui est pénalisant en temps. De plus, le commutateur permettant l'injection d'une tension sur la commande du VCO dégrade la pureté spectrale de cet oscillateur.

Un exemple d'un tel dispositif est représenté par l'invention objet du brevet déjà cité US-A- 4.523.157. Selon l'invention décrite dans ce brevet et représentée figure 3, il est inclus dans la boucle de contrôle du circuit oscillant 7, à la sortie du détecteur de phase 5 "un circuit de détection et de contrôle 10 composé d'un détecteur 8 et d'un circuit de contrôle 9". (colonne 3, lignes 63-64). Le détecteur 8 détecte si le synthétiseur à boucle de phase a été rejeté hors de sa zone d'efficacité. Si une telle détection se produit le circuit de contrôle 9 maintient la fréquence de l'oscillateur 7 en dessous de la valeur $f_r = f_T + f_l$ (équivalent de $F_V = F_X + F$ de la présente demande) à une valeur à laquelle le verrouillage de la boucle peut être maintenu. Lorsque le circuit oscillant 7 a dérivé vers sa zone d'efficacité le circuit de contrôle 9 provoque le retour du synthétiseur à son fonctionnement normal (colonne 4, lignes 1-8).

Le circuit additionnel 10 décrit dans ce brevet est donc bien un circuit où l'on détecte, une possibilité de déverrouillage et où l'on maintient un verrouillage. Dans ce brevet il s'agit d'un circuit analogique et il n'est pas prévu que la fréquence commandée s'éloigne largement de la zone de contrôle c'est pourquoi dans cette réalisation il n'est pas prévu de retour par paliers successifs.

L'objectif de l'invention est de palier les inconvénients de la technique en proposant un dispositif numérique qui permet de débloquer une boucle de phase à changement de fréquence de façon automatique et autonome.

Un autre objectif de l'invention est de fournir un tel dispositif de contrôle de boucle de phase à changement de fréquence qui soit conçu pour s'intégrer dans un circuit spécifique (ASIC) et donc d'un coût très faible.

Encore un autre objectif de l'invention est de fournir un dispositif de contrôle de boucle de phase à changement de fréquence qui permet un déblocage rapide de la boucle de phase lors des changements importants de fréquence et qui résoud le problème subsidiaire du prépositionnement de l'oscillateur lors de sa mise sous tension.

Essentiellement, l'invention consiste à prévoir, dans une boucle de phase à changement de fréquence comprenant un oscillateur commandé en tension de fréquence Fv et une fréquence de transposition Fx, un dispositif, sous forme d'un circuit, qui compare en permanence la fréquence Fv de l'oscillateur à la fréquence de transposition Fx au moyen d'un dispositif de comptage numérique et qui bloque la fréquence de battement (Fv - Fx) en entrée du détecteur phase/fréquence lorsque Fv devient inférieure à Fx, de façon à ramener la fréquence de l'oscillateur dans la plage des fréquences supérieures à Fx. En bloquant la fréquence de battement en entrée du détecteur phase/fréquence dans le cas précité, le détecteur phase/fréquence engendre un signal d'asservissement qui commande l'oscillateur vers sa butée haute. La boucle de phase peut alors être de nouveau verrouillée sans intervenir sur le signal de commande de la boucle (signal de fréquence F). A cet avantage de l'invention s'ajoute l'avantage que l'oscillateur est automatiquement prépositionné lors de la mise sous tension des circuits de la boucle, en fait dès que la comparaison de fréquence est mise en oeuvre.

Plus spécifiquement, l'invention a pour objet un dispositif de contrôle d'une boucle de phase à changement de fréquence comprenant un oscillateur commandé par un signal d'asservissement pour fournir un signal de synthèse ayant une fréquence prédéterminée, un mélangeur de signaux sensible au signal de synthèse et à un premier signal de référence ayant une première fréquence de référence pour fournir un troisième signal représentatif d'une fréquence de battement, un moyen détecteur pour détecter une différence de phase entre le troisième signal et un second signal de référence, le moyen détecteur fournissant le signal d'asservissement en réponse à cette détection, caractérisé en ce qu'il comprend un moyen comparateur de fréquence pour comparer la fréquence du signal de synthèse et la fréquence du premier signal de référence et un moyen de blocage sensible au moyen comparateur de fréquence et interposé entre le mélangeur et le moyen détecteur pour bloquer le troisième signal en entrée du moyen détecteur.

Avantageusement, le moyen comparateur de fréquence compare la fréquence du signal de synthèse et la fréquence du premier signal de référence avec un hystérésis pour fournir un signal logique de blocage représentatif du résultat de la comparaison, le signal logique ayant un premier niveau logique lorsque la fréquence du signal de synthèse est supérieure à la fréquence du premier signal de référence augmentée de l'hystérésis et le signal de blocage ayant un second niveau logique lorsque la fréquence du signal de synthèse est inférieure à la fréquence du premier signal de référence diminuée de l'hystérésis.

Le moyen de blocage est constitué d'une porte logique recevant en entrée le troisième signal et le signal de blocage pour bloquer le troisième signal lorsque le signal de blocage a un niveau logique correspondant au second niveau logique.

Le moyen de blocage est constitué d'une porte ET et le second niveau logique du signal de blocage correspond au niveau logique 0.

Le moyen comparateur de fréquence est constitué de deux moyens de comptage binaire symétriques commandables, pour le comptage jusqu'à une valeur maximum de comptage prédéterminée, respectivement par le signal de synthèse et le premier signal de référence, chaque moyen de comptage ayant une sortie pour fournir un signal de fin de comptage, et le moyen comparateur comprenant en outre un moyen sensible aux signaux de fin de comptage pour mémoriser lequel des deux moyens de comptage fournit le premier un signal de fin de comptage et pour fournir le signal de blocage.

Chaque moyen de comptage est constitué d'un compteur binaire à plusieurs étages, le premier étage ayant une commande de remise à 1 et une commande de remise à 0, les étages supérieurs ayant une commande de remise à 0, et le signal de fin de comptage d'un moyen de comptage commandant la remise à 1 du premier étage dudit moyen de comptage et la remise à 0 du premier étage du moyen de comptage symétrique.

Le moyen comparateur de fréquence comprend en outre des moyens de remise à 0 des étages supérieurs des compteurs binaires qui sont commandés par les signaux de fin de comptage.

Les moyens de remise à 0 des étages supérieurs sont constitués de portes logiques OU permettant d'appliquer simultanément à la remise à 1 du premier étage d'un compteur binaire la remise à 0 des étages supérieurs dudit compteur en réponse au signal de fin de comptage fournit par ledit compteur binaire.

La valeur maximale de comptage est supérieure à (Fx/2.F2min) +2, où
- Fx est la fréquence du premier signal de référence;
- F2min est la fréquence minimale du second signal de référence.

Le dispositif de contrôle comprend en outre deux prédiviseurs à rapport fixe pour diviser respectivement la fréquence du signal de synthèse et la fréquence du premier signal de référence avant leur application en entrée du moyen comparateur de fréquence.

D'autres caractéristiques et avantages de l'invention apparaîtront encore mieux à la lecture de la description détaillée ci-dessous faite en référence aux dessins annexés.

La figure 1 est un synoptique d'une boucle de phase à changement de fréquence connue dans l'art antérieur de la technique.

Les figures 2(a) et 2(b) représentent, sous forme de chronogrammes, le niveau du signal de contrôle en fonction de la fréquence de battement obtenue dans la boucle à verrouillage de phase de la figure 1, selon les cas F2 >F1 et F2 < F1.

La figure 3 est un synoptique d'une boucle à verrouillage de phase à changement de fréquence comportant le dispositif de contrôle selon l'invention.

La figure 4 représente, sous forme d'un chronogramme, le niveau du signal de contrôle et le niveau du signal de blocage en fonction de la fréquence de battement obtenue dans la boucle à verrouillage de phase de la figure 3, dans le cas F2 < F1.

La figure 5 est un synoptique du moyen comparateur de fréquence du dispositif de contrôle selon l'invention.

La figure 6 est une représentation détaillée d'un compteur numérique du moyen comparateur de la figure 5.

La figure 7 est un synoptique d'une boucle de phase à changement de fréquence comportant une variante du dispositif de contrôle selon l'invention.

La figure 8 est une représentation détaillée du moyen comparateur de fréquence de la figure 5 comportant des circuits numériques de comptage à 8 bits.

La figure 9 donne l'évolution du signal d'asservissement par rapport au signal de contrôle sans le dispositif de contrôle selon l'invention.

La figure 10 donne l'évolution du signal d'asservissement par rapport au signal de blocage avec le dispositif de contrôle selon l'invention.

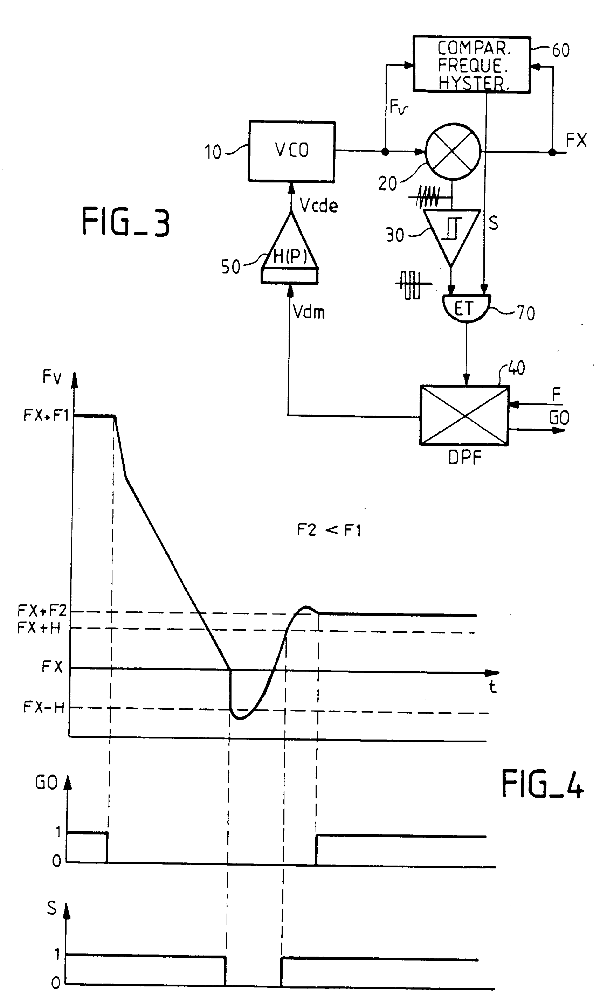

Sur les figures, les mêmes références numériques se rapportent aux mêmes éléments. En se reportant à la figure 3, la boucle de phase à changement de fréquence comprend un oscillateur (VCO) 10, un mélangeur de fréquence 20, un amplificateur limitéur 30, un détecteur phase/fréquence 40, un amplificateur pseudo-intégrateur 50. Ces circuits sont similaires à ceux représentés sur la figure 1. Selon l'invention, un comparateur de fréquence 60 à hystérésis est monté en parallèle avec le mélangeur de fréquence 20, le comparateur de fréquence commandant une porte logique ET 70 qui bloque le troisième signal fourni par le mélangeur, en entrée du détecteur phase/fréquence 40.

Le comparateur de fréquences 60 reçoit en entrée le signal de synthèse et le premier signal de référence. Il fournit en sortie un signal logique de blocage S représentatif du résultat de la comparaison de la fréquence Fv du signal de synthèse et la fréquence Fx du premier signal de référence avec un hystérésis H prédéterminé.

Le signal logique de blocage S est tel que son niveau logique est à 1 lorsque la fréquence du signal de synthèse est supérieure à la fréquence de transposition augmentée de l'hystérésis (Fv > Fx + H) et le niveau logique du signal de blocage S est à zéro lorsque la fréquence Fv du signal de synthèse est inférieure à la fréquence de transposition Fx diminuée de l'hystérésis (Fv < Fx - H). En se reportant à la figure 4 on a représenté l'évolution du niveau du signal logique de blocage S et l'évolution du signal logique de contrôle GO en fonction de la variation de fréquence du second signal de référence (signal de commande de la boucle de phase). Si on considère que la fréquence F du second signal de référence est commandée pour passer à une valeur F2 très inférieure à une valeur F1 d'origine, la boucle de phase décroche et la fréquence Fv devient plus faible que le seuil bas Fx - H du comparateur de fréquence à hystérésis. Le signal logique de blocage S passe alors instantanément au niveau logique 0. Ce signal logique de blocage est appliqué sur une entrée de la porte ET 70 tandis que le troisième signal mis en forme logique par l'amplificateur limiteur 30 est appliqué sur l'autre entrée de la porte ET. Lorsque le signal logique de blocage a un niveau logique 0, la sortie de la porte logique ET, qui est reliée au détecteur phase/fréquence, a un niveau logique 0. Le détecteur phase/fréquence 40 reçoit alors en entrée un signal continu de niveau logique 0 et le second signal de référence (sous forme logique) à la fréquence F2. En réponse à ces deux signaux, le détecteur phase/fréquence 40 détecte un écart de phase maximum et fournit un signal d'asservissement (une tension continue) ayant un niveau maximum. Ce signal d'asservissement est adapté à la dynamique d'entrée de l'oscillateur par l'amplificateur pseudo-intégrateur 50 ayant une fonction de transfert H(p) pour commander l'oscillateur 10 en fréquence croissantes jusqu'à passer au-dessus du seuil haut Fx + H. Le signal logique de blocage repasse alors au niveau logique 1 pour laisser passer la fréquence de battement en entrée du détecteur phase/fréquence 40. Le détecteur phase/fréquence 40 délivre alors un signal d'asservissement commandant l'oscillateur 10 pour raccrocher en phase la boucle de phase du fait que l'hystérésis H a une valeur voisine de la valeur minimum de la fréquence F2 (F2min). Par conséquent, le dispositif de contrôle de la boucle de phase à changement de fréquence est autonome et permet à la boucle de phase de se verrouiller en un temps très court quelle que soit la commande de la fréquence F du second signal de référence, y compris lors de la mise sous tension des circuits de la boucle de phase.

Sur la figure 3, le moyen de blocage 70 est une porte logique ET interposée entre l'amplificateur limiteur 30 et le détecteur phase/fréquence 40. Par conséquent, tant que le niveau logique du signal de blocage S est à 1, c'est à dire quand la fréquence Fv du signal de synthèse est supérieure à la fréquence Fx du premier signal de référence augmentée de l'hystérisis H, la porte logique ET laisse passer le signal représentatif de la fréquence de battement Fv - Fx vers le détecteur phase/fréquence. Lorsque le niveau logique du signal de blocage S est égal à 0, c'est à dire quand la fréquence Fv du signal de synthèse est inférieure à la fréquence Fx du premier signal de référence diminuée de l'hystérisis H, la porte logique ET bloque le signal représentatif de la fréquence de battement en entrée du détecteur phase/fréquence 40.

Il est aisé de remplacer la porte logique ET par des portes logiques OU, NON-OU, NON-ET ou analogue et utiliser directement le signal logique de blocage S ou un signal logique complément du signal S (complément à 2) selon le type de porte utilisé pour commander la porte logique considérée.

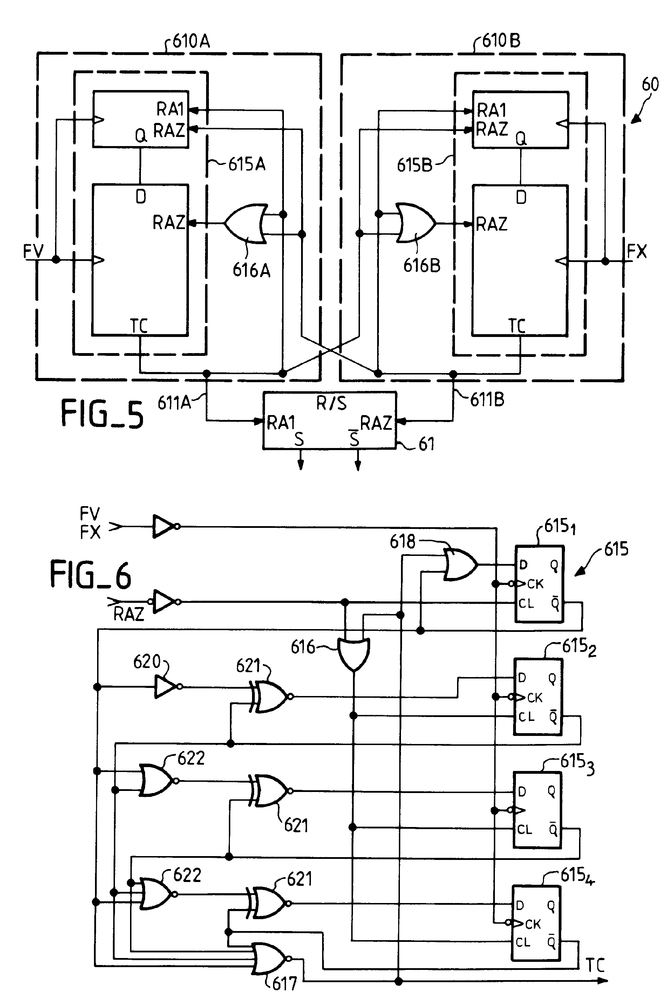

Nous allons maintenant décrire le comparateur de fréquence à hystérésis 60 en nous référant à la figure 5. Il comprend deux moyens de comptage 610A, 610B qui sont symétriques. Les moyens de comptage, des compteurs binaires, sont commandés respectivement par le signal de synthèse à la fréquence Fv et le premier signal de référence à la fréquence Fx pour compter jusqu'à une valeur maximum de comptage prédéterminée, commune pour les deux compteurs. Les compteurs binaires 610A,610B ont chacun une sortie 611A,611B pour fournir des signaux de fin de comptage TC. Les signaux TC de fin de comptage sont fournis à une bascule logique 61 (une bascule R/S) qui délivre le signal logique de blocage S ainsi qu'un signal complémentaire correspondant au complément à 2 du signal logique de blocage S. Sur la figure 5, le signal TC du compteur 610A alimente l'entrée de remise à 1 de la bascule 61 et le signal TC du compteur 610B alimente la remise à 0 de la bascule 61. Suivant le type de porte utilisé pour le moyen de blocage 70, on choisira un des deux signaux logiques de blocage de manière à bloquer la fréquence de battement convenablement.

Chaque compteur binaire comprend plusieurs étages 615 visibles sur les figures 5 et 6. Le premier étage de comptage (le bit de poids le plus faible) comporte une entrée de commande de remise à 1 (RA1) et une entrée de commande de remise à 0 (RAZ). Les étages supérieurs comportent uniquement une entrée de commande de remise à 0 (RAZ). Le signal de fin de comptage TC de chaque compteur binaire 610 commande la remise à 1 du premier étage de comptage du compteur considéré et la remise à 0 du premier étage du compteur binaire symétrique. Deux portes logiques OU 616A, 616B commandées respectivement par les signaux de fin de comptage TC permettent d'appliquer simultanément la remise à 1 du premier étage et la remise à 0 des étages supérieurs des compteurs binaires.

Le fonctionnement du comparateur de fréquence est le suivant. En supposant la fréquence Fv plus grande que la fréquence Fx, le compteur 610A de l'horloge Fv parvient le premier en fin de comptage et sa sortie TC qui passe à 1 :

- remet à 0 les étages du compteur 610B de l'horloge Fx
- remet à 1 le premier étage et à 0 les étages supérieurs du compteur de l'horloge Fv.

Au cycle suivant de comptage, le compteur 610A de l'horloge Fv part de 1 tandis que le compteur 610B de l'horloge Fx part de 0.

Si $N=2^q$ est la valeur de comptage maximum, q étant le nombre d'étages dans un compteur, le compteur 610A atteint la fin de comptage (état N-1) après N-2 périodes et son signal de fin de comptage TC passe à 1 ce qui positionne la bascule R/S à 1 et donc le signal logique de blocage au niveau logique 1. Pendant ce temps le compteur 610B qui était parti de 0 n'a pas pu atteindre la fin de comptage car la fréquence Fv est supérieure à la fréquence Fx, et le même cycle recommence. Par conséquent la fréquence la plus élevée impose toujours à l'autre fréquence un handicap d'un coup de comptage. Pour inverser cette situation, la fréquence Fx doit devenir plus élevée que Fv d'une quantité telle que le compteur 610B prenne 2 coup de comptage en un seul cycle.

Cette condition se traduit par

$$Fv = Fx \cdot (N-1)/(N-2)$$

et en posant $Fv = Fx +/- H$,

l'hystérésis vaut $H = |FV - Fx|$

d'où $\underline{H = Fx/(N-2)}$

Lorsque la fréquence Fv du signal de sortie de l'oscillateur 10 est renvoyée de $Fv = Fx-H$ à $Fv = Fx+H$ (figure 4), l'hystérésis H doit être tel que : $H < 2.F2$ min (F2min étant la valeur minimale de la fréquence F du second signal de référence), pour que la boucle se raccroche convenablement. Par conséquent on en déduit la relation:

$$\underline{N > (Fx/2F2min) + 2} \quad (2)$$

En supposant l'exemple $Fx = 20$ MHZ et $F2min = 40$ kHz, d'après la relation (2), la valeur de N implique l'utilisation d'un compteur 8 bits. Sur la figure 6, on a représenté un compteur binaire 615 à 4 bits facilement extensible à 8 bits. Ce compteur binaire à fonctionnement synchrone comprend:

- une entrée d'horloge pour recevoir l'une des fréquences Fv ou Fx,
- une entrée de remise à 0 asynchrone (RAZ),
- une sortie de fin de comptage TC.

Ce compteur à quatre étages a un premier étage (bascule $615_1$) avec un "CLEAR" asynchrone et un chargement à 1 synchrone tandis que tous les étages supérieurs (bascules $615_2$ à $615_4$) n'ont que le "CLEAR" asynchrone. Une porte logique NON-OU 617 à 4 entrées réalise le décodage de fin de comptage pour fournir le signal TC qui est envoyé :

- sur l'entrée "D" de la première bascule $615_1$, via une porte logique OU 618 de rebouclage pour faire la remise à 1 synchrone du premier étage au coup d'horloge suivant,
- sur une porte logique OU 616 pour faire la remise à 0 des trois étages supérieurs.

Les bascules sont reliées entre elles par leur entrée "D" et leur sortie "Q" à travers des portes logiques 620,621,622 pour compter du nombre binaire 0000 à 1111. L'entrée de remise à 0 (RAZ) est reliée à la sortie du compteur symétrique pour recevoir l'autre signal TC. Ceci permet au compteur de repartir à chaque cycle de l'état 0001 tant que l'autre compteur ne lui envoie pas de signal de remise à 0 (RAZ) qui le ferait partir de l'état 0000.

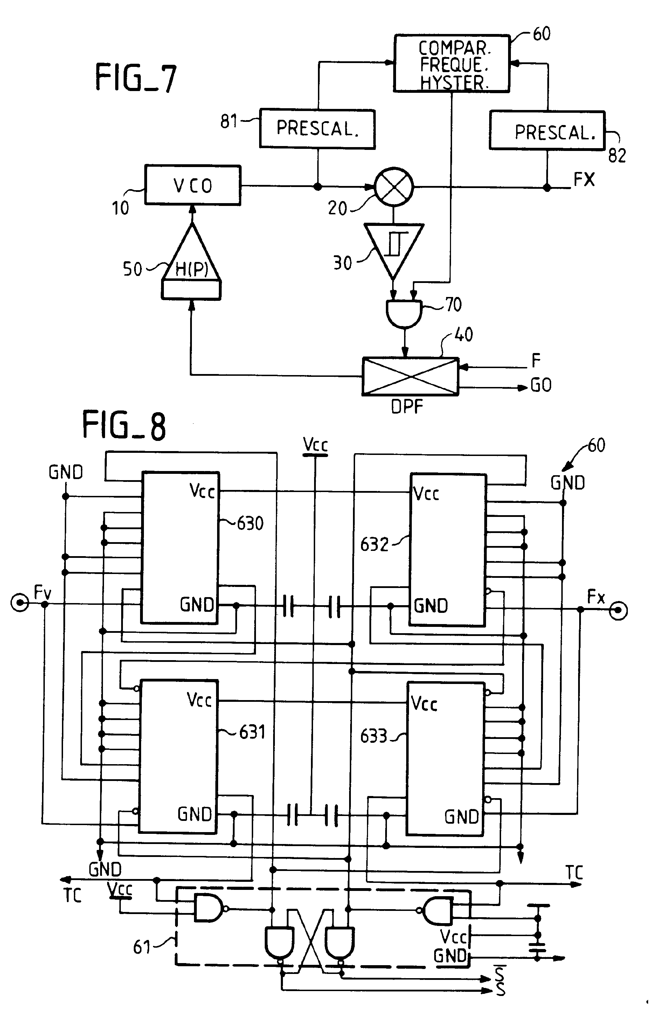

Sur la figure 8, on a représenté un comparateur de fréquence comprenant quatre compteurs binaires 630,631,632,633 à 4 bits, du type 74F161, couplés deux à deux pour former deux compteurs binaires 8 bits symétriques. Les signaux TC de fin de comptage sont appliqués en entrée d'un circuit 61 du type 74F00 pour fournir le ou les signaux logiques de blocage S.

En se reportant maintenant à la figure 7, le dispositif de contrôle selon l'invention comporte en outre deux prédiviseurs, par exemple binaires, à rapport fixe (4, 8, 16 ou plus) 81,82 (par exemple du type ECL 1/8 SP8691A à sortie TTL). Les prédiviseurs 81,82 sont placés en amont des deux entrées du comparateur de fréquence 60 pour adapter les fréquences de synthèse et de référence (cas de fréquences très élevées) aux caractéristiques fréquentielles du comparateur de fréquence.

La valeur de l'hystérésis étant dépendante de la longueur des compteurs (N), il est utile de prévoir une pluralité de sorties TC de fin de comptage pour chaque compteur, correspondant à des valeurs maximales de comptage différentes, sélectionnées par un multiplexeur, de manière à rendre "universel" le comparateur de fréquence pour une réalisation sous forme de circuit intégré (ASIC).

Le dispositif de contrôle d'une boucle de phase à changement de fréquence a été testé pour les valeurs suivantes de la boucle de phase:

$$Fx = 1024 \, F2$$

$$Fmin = 20.86 \text{ kHz et } Fmax > 400 \text{ kHz}$$

Le saut de fréquence appliqué dans la boucle est :

- F1=390 KHz
- F2 jusqu'à 20,86 KHZ

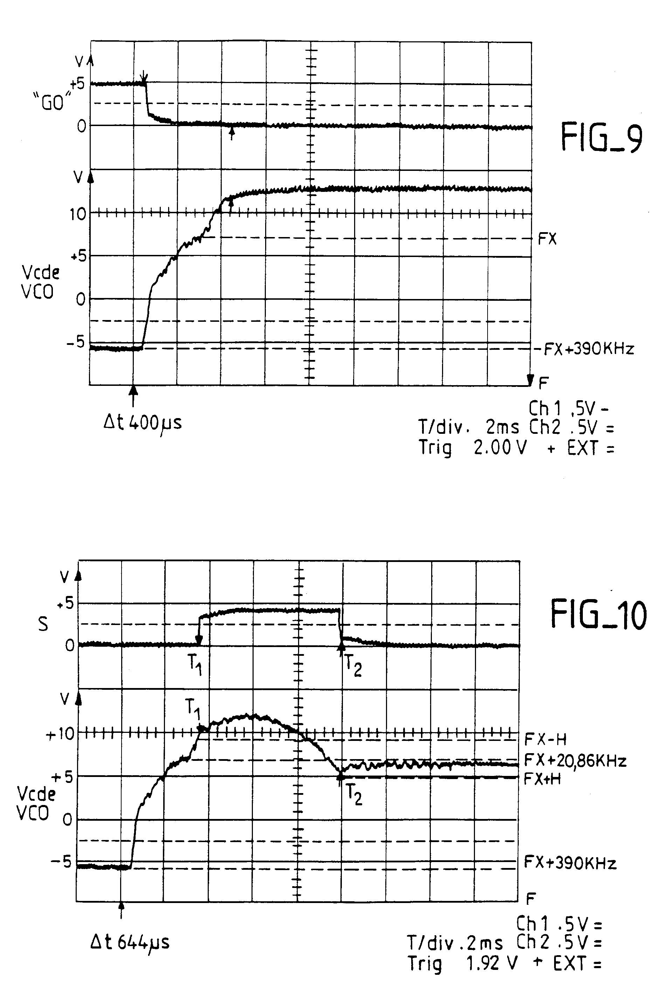

En l'absence du dispositif de contrôle de boucle de phase selon l'invention, dès que le rapport F2/F1 est supérieur à 4 la boucle se bloque, l'oscillateur reste en butée basse et le signal de contrôle GO fourni par le détecteur phase/fréquence 40 reste au niveau 0. La figure 9 traduit une telle situation relevée sur un oscilloscope à mémoire où on voit la tension de commande (Vcde) de l'oscillateur (VCO ) et le signal de contrôle GO.

Avec le dispositif de contrôle de la figure 8 selon l'invention, en se référant à la figure 10, on voit que la variation parabolique de la tension de commande (Vcde) de l'oscillateur qui part de Fx-H, atteint un maximum à environ t1=230 uS et passe à la fréquence Fx+H au temps t2=644 uS. Après quoi, la boucle se raccroche en phase et l'oscillateur s'arrête à la fréquence de consigne Fx+20,86 kHz. On voit aussi sur cette figure , le changement de niveau logique du signal logique de blocage S (représenté par son complément à 2 sur la figure 10) aux instants t1 et t2.

Nous allons maintenant établir les performances d'une boucle de phase à changement de fréquence comportant un dispositif de contrôle selon l'invention. Une telle boucle de phase comprend les éléments suivants :

- un oscillateur (VCO) de pente de commande Ko en Hz/V;
- un détecteur phase/fréquence (DPF) délivrant une tension Vd=(Vdm/2Kpi).PH = Kd.PH, où PH est la phase en radians;
- un amplificateur pseudo-intégrateur de fonction de transfert H1(p) = (1+t2p)/t1p

La fonction de transfert en boucle ouverte de la boucle de phase est alors

$$H(p) = Kv.((1 + t2p)/t1p.p)$$

où $Kv=2.Pi.Ko.Kd$ (gain de boucle)

Cette boucle a une pulsation de coupure Wc et une pulsation propre Wn qui valent :

$$Wc = Kv.(t2/t1)$$
$$Wn = \sqrt{Kv/t1}$$

Si l'on a commandé la fréquence F du second signal de référence pour passer de la fréquence F1 à la fréquence F2 très inférieure à la fréquence F1, la boucle de phase se bloque et l'oscillateur dépasse la butée basse Fx-H.

A cet instant la sortie du comparateur de fréquence à hystérésis passe à zéro et bloque l'entrée Fv-Fx du détecteur de phase qui dès lors ne reçoit que le signal F2 sur son autre entrée.

La tension de sortie du détecteur de phase/fréquence qui était à -Vdm va remonter à +Vdm en 2K périodes du signal F2.

Le temps de cette remontée est donc To=2K/F2
cette rampe de tension a pour équation V=Vdm(F2/K.t-1)
et sa transformée de Laplace est $V(p)=Vdm(F2/_{K}p^2 - 1/_p)$

Ce signal est appliqué à l'amplificateur pseudo-intégrateur dont la fonction de transfert est

$$H(p) = (1 + t2p)/t1p$$

La tension en sortie engendrée par l'amplificateur pseudo-intégrateur est

$$Vs(t) = \frac{Vdm}{t1} [F2/2K.t^2 + (t2F2/(K - 1))t - t2]$$

La fréquence de l'oscillateur est fv(t) = Ko∗Vs(t)
soit

$$fv(t) = Ko∗ \frac{Vdm}{t1} [F2/2K.t^2 + (t2F2/(K - 1))t - t2]$$

Cette loi est une parabole qui passe par un minimum au temps :

$$T1 = K/F2 - t2$$

L'excursion de fréquence à partir du départ est
$$Df = fv(T1) - fv(T0)$$

soit :

$$Df = Ko.Vdm/t1[t2 - K/2F2 - F2.t2^2/2K]$$

Le signal logique de blocage S change de niveau logique lorsque la fréquence de l'oscillateur atteint la valeur fv=Fx+H soit au temps T2 tel que :

$$fv(T2)=fv(T0)+2H$$ ; H étant l'hystérésis H=Fx/(N-2)

L'équation donnant T2 est alors en fonction des caractéristiques Wc, Wn, K, Fx, F2 :

$$T_2 = \frac{K}{F2} - \frac{Wc}{Wn^2} + \frac{1}{F2.Wn^2}\sqrt{(Wc.F2 - K.Wn^2)^2 + \frac{4.Fx.F2.Wn^2}{N - 2}}$$

## Revendications

1. Un dispositif de contrôle d'une boucle de phase à changement de fréquence comprenant un oscillateur (10) commandé par un signal d'asservissement pour fournir un signal de synthèse ayant une fréquence prédéterminée, un mélangeur (20) de signaux sensible au signal de synthèse et à un premier signal de référence ayant une première fréquence de référence pour fournir un troisième signal représentatif d'une fréquence de battement, un moyen détecteur (40) pour détecter une différence de phase entre le troisième signal et un second signal de référence, le moyen détecteur fournissant le signal d'asservissement en réponse à cette détection, caractérisé en ce qu'il comprend un moyen comparateur (60) de fréquence pour comparer la fréquence du signal de synthèse et la fréquence du premier signal de référence et un moyen de blocage (70) sensible au moyen comparateur de fréquence et interposé entre le mélangeur et le moyen détecteur pour bloquer le troisième signal en entrée du moyen détecteur (40).

2. Le dispositif selon la revendication 1, dans lequel le moyen comparateur de fréquence (60) compare la fréquence du signal de synthèse et la fréquence du premier signal de référence avec un hystérésis pour fournir un signal logique de blocage représentatif du résultat de la comparaison, le signal logique ayant un premier niveau logique lorsque la fréquence du signal de synthèse est supérieure à la fréquence du premier signal de référence augmentée de l'hystérésis et le signal de blocage ayant un second niveau logique lorsque la fréquence du signal de synthèse est inférieure à la fréquence du premier signal de référence diminuée de l'hystérésis.

3. Le dispositif selon la revendication 2, dans lequel le moyen de blocage (70) est constitué d'une porte logique recevant en entrée le troisième signal et le signal de blocage pour bloquer le troisième signal lorsque le signal de blocage a un niveau logique correspondant au second niveau logique.

4. Le dispositif selon la revendication 3, dans lequel le moyen de blocage (70) est constitué d'une porte ET et où le second niveau logique du signal de blocage correspond au niveau logique 0.

5. Le dispositif selon la revendication 2, dans lequel le moyen comparateur de fréquence (60) est constitué de deux moyens de comptage binaire (610A, 610B) symétriques commandables, pour le comptage jusqu'à une valeur maximum de comptage prédéterminée, respectivement par le signal de synthèse et le premier signal de référence, chaque moyen de comptage ayant une sortie (611A, 611B) pour fournir un signal de fin de comptage, et le moyen comparateur (60) comprenant en outre un moyen sensible (61) aux signaux de fin de comptage pour fournir le signal de blocage.

6. Le dispositif selon la revendication 5, dans lequel chaque moyen de comptage est constitué d'un compteur binaire (615A, 615B) à plusieurs étages, le premier étage ($615_1$) ayant une commande de remise à 1 et une commande de remise à 0, les étages supérieurs ($615_2$ - $615_4$) ayant une commande de remise à 0, et le signal de fin de comptage d'un moyen de comptage commandant la remise à 1 du premier étage dudit moyen de comptage et la remise à 0 du premier étage du moyen de comptage symétrique.

7. Le dispositif selon la revendication 6, dans lequel le moyen comparateur de fréquence (60) comprend en outre des moyens (616A, 616B) de remise à 0 des étages supérieurs ($615_2$ - $615_4$) des compteurs binaires qui sont commandés par les signaux de fin de comptage.

8. Le dispositif selon la revendication 7, dans lequel les moyens de remise à 0 (616A - 616B) des étages supérieurs ($615_2$ - $615_4$) sont constitués de portes logiques OU permettant d'appliquer simultanément à la remise à 1 du premier étage d'un compteur binaire la remise à 0 des étages supérieurs dudit compteur en réponse au signal de fin de comptage fournit par ledit compteur binaire.

9. Le dispositif selon la revendication 6, dans lequel la valeur maximale de comptage est supérieure à (Fx/2.F2min) +2, où
   - Fx est la fréquence du premier signal de référence;
   - F2min est la fréquence minimale du second signal de référence.

10. Le dispositif selon l'une quelconque des revendications précédentes comprenant en outre deux prédiviseurs (81, 82) à rapport fixe pour diviser respectivement la fréquence du signal de synthèse et la fréquence du premier signal de référence avant leur application en entrée du moyen comparateur de fréquence.

**Patentansprüche**

1. Steuervorrichtung für eine Phasenschleife mit Frequenzveränderung, die einen von einem Regelsignal gesteuerten Oszillator (10) zur Lieferung eines Synthesesignals einer vorgegebenen Frequenz, ein Signalmischglied (20), das auf das Synthesesignal und ein erstes Bezugssignal mit einer ersten Bezugsfrequenz anspricht, um ein drittes Signal zu liefern, das für eine Überlagerungsfrequenz repräsentativ ist, ein Detektormittel (40), um eine Phasendifferenz zwischen dem dritten Signal und dem zweiten Bezugssignal zu erfassen, wobei das Detektormittel das Regelsignal aufgrund dieser Erfassung liefert, dadurch gekennzeichnet, daß die Vorrichtung ein Frequenzkomparatormittel (60), um die Frequenz des Synthesesignals und die Frequenz des ersten Bezugssignals miteinander zu vergleichen, und ein Blockiermittel (70) enthält, das auf das Frequenzkomparatormittel anspricht und zwischen dem Mischglied und dem Detektormittel liegt, um das dritte Signal am Eingang des Detektormittels (40) zu blockieren.

2. Vorrichtung nach Anspruch 1, in der das Frequenzkomparatormittel (60) die Frequenz des Synthesesignals mit der Frequenz des ersten Bezugssignals unter Beachtung einer Hysterese vergleicht und ein logisches Blockiersignal liefert, das für das Ergebnis des Vergleichs repräsentativ ist, wobei das logische Signal einen ersten logischen Wert annimmt, wenn die Frequenz des Synthesesignals größer als die Frequenz des ersten Bezugssignals plus der Hysterese wird, und einen zweiten logischen Wert, wenn die Frequenz des Synthesesignals kleiner als die Frequenz des ersten Bezugssignals minus der Hysterese wird.

3. Vorrichtung nach Anspruch 2, in der das Blockiermittel (70) aus einem logischen Tor besteht, das am Eingang das dritte Signal und das Blockiersignal empfängt, um das dritte Signal zu sperren, wenn das Blockiersignal einen logischen Wert entsprechend dem zweiten logischen Pegel annimmt.

4. Vorrichtung nach Anspruch 3, in der das Blockiermittel (70) aus einem UND-Tor besteht und der zweite logische Wert des Blockiersignals dem logischen Pegel 0 entspricht.

5. Vorrichtung nach Anspruch 2, in der das Frequenzkomparatormittel (60) aus zwei symmetrischen Binärzählermitteln (610A, 610B) besteht, die für einen Zählzyklus bis zu einem vorgegebenen Höchstzählwert vom Synthesesignal bzw. dem ersten Bezugssignal gesteuert werden, wobei jedes Zählmittel an einem Ausgang (611A, 611B) ein Zählendesignal liefert und wobei das Komparatormittel (60) außerdem ein auf diese Zählendesignale ansprechendes Mittel (61) aufweist, um das Blockiersignal zu liefern.

6. Vorrichtung nach Anspruch 5, in der jedes Zählmittel aus einem mehrstufigen Binärzähler (615A, 615B) besteht, wobei die erste Stufe ($615_1$) einen Setzeingang auf 1 und einen Nullsetzungseingang besitzt, während die höheren Stufen ($615_2$ bis $615_4$) einen Nullsetzungseingang besitzen, und wobei das Zählendesignal eines Zählmittels die 1-Setzung der ersten Stufe des Zählmittels und die Nullsetzung der ersten Stufe des symmetrischen Zählmittels steuert.

7. Vorrichtung nach Anspruch 6, in der das Frequenzkomparatormittel (60) außerdem Mittel (616A, 616B) zur Nullsetzung der höheren Stufen ($615_2$ bis $615_4$) der Binärzähler aufweist, die von den Zählendesignalen gesteuert werden.

8. Vorrichtung nach Anspruch 7, in der die Nullsetzungsmittel (616A, 616B) der höheren Stufen ($615_2$ bis $615_4$) aus logischen ODER-Toren bestehen, die zugleich mit der 1-Setzung der ersten Stufe eines Zählers die Nullsetzung der höheren Stufen des Zählers aufgrund des von diesem Binärzähler gelieferten Zählendesignals bewirken können.

9. Vorrichtung nach Anspruch 6, in der der höchste Zählwert größer als (Fx/2.F2min)+2 ist, wobei Fx die Frequenz des ersten Bezugssignals und F2min die Mindestfrequenz des zweiten Bezugssignals ist.

10. Vorrichtung nach einem beliebigen der vorhergehenden Ansprüche, in der weiter zwei Vor-Teiler (81, 82) mit festem Teilerverhältnis vorgesehen sind, um die Frequenz des Synthesesignals bzw. die Frequenz des ersten Bezugssignals herunterzuteilen, ehe sie an den Eingang des Frequenzkomparatormittels angelegt werden.

**Claims**

1. Control device for a frequency-changing phase loop comprising an oscillator (10) driven by a slaving signal for supplying a synthesis signal having a predetermined frequency, a signal mixer (20) sensitive to the synthesis signal and to a first reference signal having a first reference frequency for supplying a third signal representing a beat frequency, a detector means (40) for detecting a phase difference between the third signal and a second reference signal, the detector means supplying the slaving signal in response to this detection, characterized in that it comprises a frequency comparator means (60) for comparing the frequency of the synthesis signal and the frequency of the first reference signal, and a blocking means (70) sensitive to the frequency comparator means and interposed between the mixer and the detector means in order to block the third signal at the input of the detector means (40).

2. Device according to Claim 1, in which the frequency comparator means (60) compares the frequency of the synthesis signal and the frequency of the first reference signal with hysteresis in order to supply a blocking logic signal representing the result of the comparison, the logic signal having a first logic level when the frequency of the synthesis signal is higher than the frequency of the first reference signal increased by the hysteresis and the blocking signal having a second logic level when the frequency of the synthesis signal is lower than the frequency of the first reference signal reduced by the hysteresis.

3. Device according to Claim 2, in which the blocking means (70) consists of a logic gate receiving as input the third signal and the blocking signal in order to block the third signal when the blocking signal has a logic level corresponding to the second logic level.

4. Device according to Claim 3, in which the blocking means (70) consists of an AND gate, and in which the second logic level of the blocking signal corresponds to the logic level 0.

5. Device according to Claim 2, in which the frequency comparator means (60) consists of two controllable, symmetric binary counting means (610A, 610B), for counting up to a maximum count value predetermined respectively by the synthesis signal and the first reference signal, each counting means having an output (611A, 611B) for supplying an end-of-count signal, and the comparator means (60) further comprising a means (61) sensitive to the end-of-count signals in order to supply the blocking signal.

6. Device according to Claim 5, in which each counting means consists of a binary counter (615A, 615B) with several stages, the first stage ($615_1$) having a 1-reset control and a 0-reset control, the higher stages ($615_2$-$615_4$) having a 0-reset control, and the end-of-count signal of a counting means controlling the resetting of the first stage of the said counting means to 1 and the resetting of the first stage of the symmetric counting means to 0.

7. Device according to Claim 6, in which the frequency comparator means (60) further comprises means (616A, 616B) for resetting to 0 the higher stages ($615_2$-$615_4$) of the binary counters which are controlled by the end-of-count signals.

8. Device according to Claim 7, in which the means (616A-616B) for resetting the higher stages ($615_2$-$615_4$) to 0 consist of OR logic gates making it possible, simulta- neously with the resetting of the first stage of the binary counter to 1, to apply the 0-reset of the higher stages of the said counter, in response to the end-of-count signal supplied by the said binary counter.

9. Device according to Claim 6, in which the maximum count value is higher than (Fx/2.F2min) + 2, in which
   - Fx is the frequency of the first reference signal;
   - F2min is the minimum frequency of the second reference signal.

10. Device according to any one of the preceding claims further comprising two fixed-ratio predividers (81, 82) for dividing respectively the frequency of the synthesis signal and the frequency of the first reference signal before they are applied as input to the frequency comparator means.

EP 0 518 729 B1

FIG_1

FIG_2a

$F2 > F1$

FIG_2b

$F2 < F1$

butée haute

butée basse

11

FIG_3

COMPAR. FREQUE. HYSTER. 60

10 VCO

Fv

20 ⊗ FX

Vcde

30 S

50 H(P)

Vdm

ET 70

40

F
GO

DPF

FIG_4

Fv

FX+F1

F2 < F1

FX+F2
FX+H

FX

t

FX-H

GO

1

0

S

1

0

FIG_5

FIG_6

# FIG_7

# FIG_8

FIG_9

FIG_10